# EUROPEAN PATENT APPLICATION

(11) **EP 4 780 166 A2**
(43) Date of publication of application: **22.07.2026**
(21) Application number: 25224626.9
(22) Date of filing: 17.12.2025
(51) Int. Cl.: H10D 89/10, H10W 20/43, H10D 84/85, H10D 84/90

(54) **INTEGRATED CIRCUIT INCLUDING EXTENDING PINS AND METHOD FOR DESIGNING THE SAME**

(30) Priority: 15.01.2025 KR 20250006089
(71) Applicant: Samsung Electronics Co., Ltd., Suwon-si, Gyeonggi-do 16677 (KR)
(72) Inventor: YU, Jisu, 16677 Suwon-si (KR); YANG, Jaewan, 16677 Suwon-si (KR); SONG, Youngwoo, 16677 Suwon-si (KR)
(74) Representative: Marks & Clerk LLP

(57) **Abstract**

Provided is an integrated circuit which may include a first cell placed in a first row extending in a first direction and including a first pin above a substrate and a second cell placed in the first row including a second pin above the substrate, wherein the first pin and the second pin are included in a first pattern in a first wiring layer above the substrate, the first pattern extending in the first direction along a boundary between the first row and a second row adjacent to the first row.

## Description

### BACKGROUND

### 1. Field

Example embodiments relate to an integrated circuit, and more particularly, to an integrated circuit including an extending pin and a method of designing the same.

### 2. Description of Related Art

An integrated circuit may include a plurality of standard cells. The standard cells may have input pins and output pins, and the pins of the standard cells may be connected to each other through wiring. With developments in semiconductor process, a size of standard cells may decrease and a number of standard cells included in the integrated circuit may increase. Accordingly, it may become important to secure routing resources for connecting the pins of the standard cells to each other.

### SUMMARY

One or more example embodiments of the present disclosure provide an integrated circuit with increased routing resources and a method of designing the same.

According to an aspect of an example embodiment of the present disclosure, there is provided an integrated circuit including: a first cell placed in a first row extending in a first direction and including a first pin above a substrate, and a second cell placed in the first row and including a second pin above the substrate. The first pin and the second pin are included in a first pattern in a first wiring layer above the substrate, the first pattern extending in the first direction along a boundary between the first row and a second row adjacent to the first row.

According to an aspect of an example embodiment of the present disclosure, there is provided an integrated circuit including a first cell and a second cell, which are placed in a first row extending in a first direction, and a first pattern in a first wiring layer on a substrate, the first pattern extending in the first direction along a boundary between the first row and a second row adjacent to the first row. Each of the first cell and the second cell includes a pin included in the first pattern.

According to an aspect of an example embodiment of the present disclosure, there is provided a method of designing an integrated circuit including a plurality of cells, the method including placing a plurality of cells and routing pins of the plurality of cells, wherein the placing the plurality of cells and the routing pins of the plurality of cells include: placing a first cell including a first pin which extends in a first direction along a boundary between a first row and a second row, which are adjacent to each other and extending in the first direction; placing a second cell including a second pin which extends in the first direction along the boundary between the first row and the second row; and generating a first pattern by merging the first pin and the second pin in a first wiring layer on a substrate.

The placing the first cell and the placing the second cell may include the placing the first cell and the second cell each including: a device on the substrate; a backside pattern extending in the first direction below the substrate and configured to provide a supply voltage to the first cell and the second cell; and a backside contact between the device and the backside pattern.

The placing the first cell may include placing the first cell, which includes a third pin extending in the first direction in the first wiring layer, a width of the first pattern being greater than a width of the third pin of the first cell.

The placing the plurality of cells and the routing pins of the plurality of cells may further include placing a third cell, which includes at least one fourth pin, adjacent to the first cell in the second row, and wherein the at least one fourth pin of the third cell is apart from the first pattern.

The placing the first cell may include placing a fourth cell which provides an identical function as the first cell; and replacing the fourth cell with the first cell based on determining that the fourth cell is replaceable with the first cell.

The method may further include obtaining at least one mask which is fabricated based on the output data; and manufacturing the integrated circuit based on the at least one mask.

At least some of the above and other features of the invention are set out in the claims.

### BRIEF DESCRIPTION OF FIGURES

These and/or other aspects, features, and advantages of the present disclosure will become apparent and more readily appreciated from the following description of example embodiments, taken in conjunction with the accompanying drawings of which:
FIGS. 1A and 1B illustrate layouts of an integrated circuit according to example embodiments;
FIGS. 2A through 2D illustrate examples of a device according to example embodiments;
FIG. 3 illustrates a layout of an integrated circuit according to an example embodiment;
FIGS. 4A and 4B illustrate layouts of an integrated circuit according to example embodiments;
FIGS. 5A and 5B illustrate examples of a cell according to example embodiments;
FIG. 6 illustrates a cell according to an example embodiment;
FIG. 7 illustrates a layout of an integrated circuit according to an example embodiment;
FIG. 8 illustrates a layout of an integrated circuit according to an example embodiment;
FIG. 9 is a flowchart illustrating a method of manufacturing an integrated circuit according to an example embodiment;
FIG. 10 is a flowchart illustrating a method of designing an integrated circuit according to an example embodiment;
FIG. 11 is a flowchart illustrating a method of designing an integrated circuit according to an example embodiment;
FIG. 12 illustrates a layout of an integrated circuit according to an example embodiment;
FIG. 13 is a block diagram illustrating a system-on-chip (SoC) according to an example embodiment; and
FIG. 14 is a block diagram illustrating a computing system including a memory for storing a program according to an example embodiment.

### DETAILED DESCRIPTION

Hereinafter, example embodiments will be described with reference to the accompanying drawings.

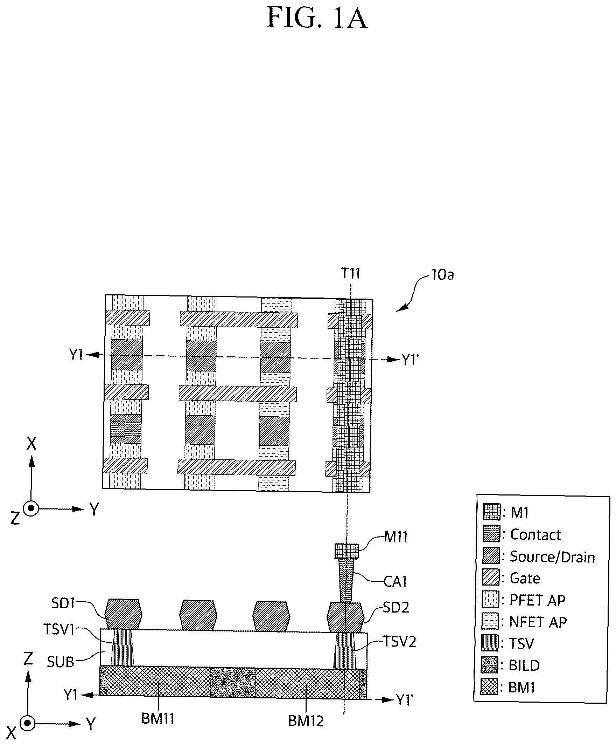

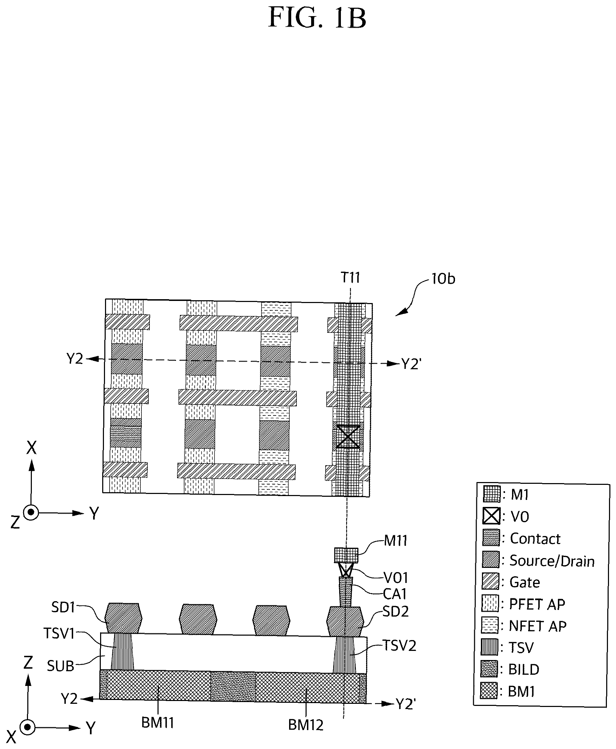

FIGS. 1A and 1B illustrate layouts of an integrated circuit according to example embodiments. FIG. 1A illustrates a top plan view of a layout 10a, and a cross-sectional view of the layout 10a cut along line Y1-Y1' of the top plan view of the layout 10a, and FIG. 1B illustrates a top plan view of a layout 10b, and a cross-sectional view of the layout 10b cut along line Y2-Y2' of the top plan view of the layout 10b. Hereinafter, redundant details in the descriptions of FIGS. 1A and 1B will be omitted.

Herein, an X-axis direction and a Y-axis direction may be referred to as a first direction and a second direction respectively, and a Z-axis direction may be referred to as a perpendicular direction or a third direction. A plane having the X-axis and Y-axis may be referred to as a horizontal plane, an element disposed in a +Z direction relative to another element may be understood as being above the other element, and an element disposed in a - Z direction relative to another element may be understood as being below the other element. Also, a surface area of an element may refer to a size of an area occupied by an element on a plane parallel to the horizontal plane, and a width of an element may refer to a length in a direction perpendicular to a direction the element extends. A surface on an upper side in the +Z direction may be referred to as a top surface, a surface on a lower side in the -Z direction may be referred to as a bottom surface, and a surface on a side in ±X or ±Y direction may be referred to as a lateral surface. In the drawings herein, only some of the layers may be illustrated for brevity, and a via that connects an upper pattern to a lower pattern may be shown, even though the via is placed below the upper pattern, to facilitate better understanding. Also, a pattern made of a conductive material, such as a pattern of a wiring layer, may be referred to as a conductive pattern or simply as a pattern. Herein, elements that are electrically connected to each other may be described as simply being connected.

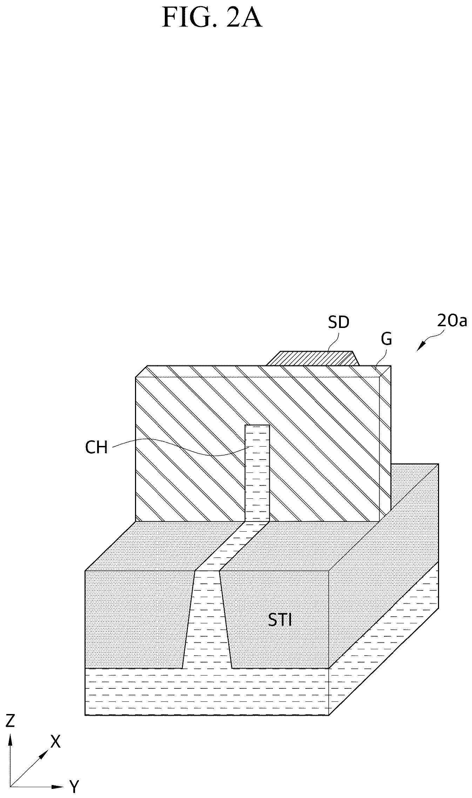

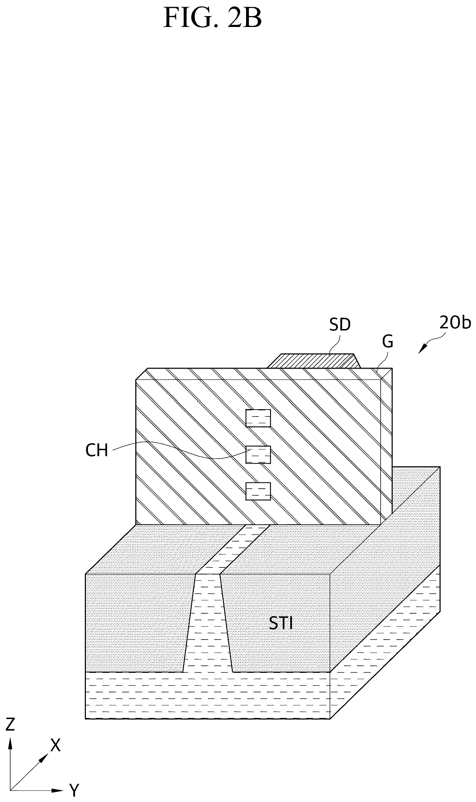

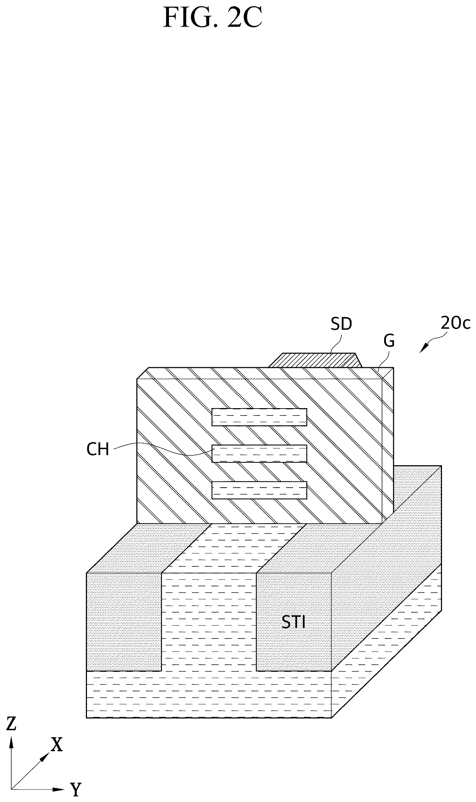

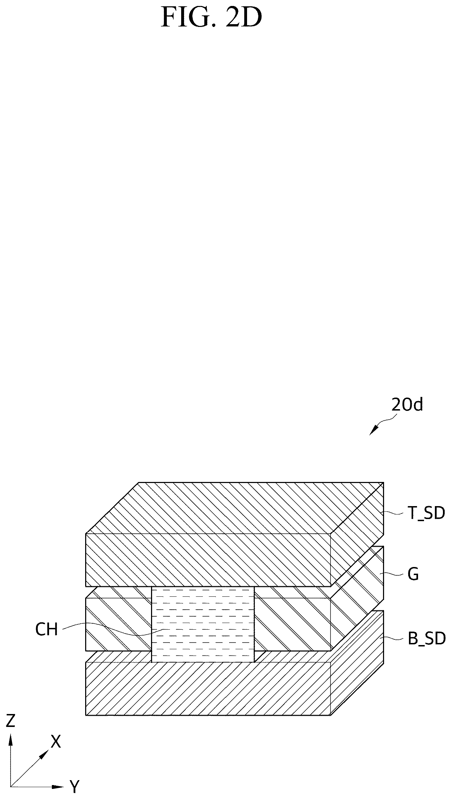

An integrated circuit may include devices, such as transistors, that are disposed on a substrate SUB. Examples of the devices disposed on the substrate SUB will be described with reference to FIGS. 2A, 2B, 2C, and 2D. In addition, the integrated circuit may include patterns extending above the devices as well as patterns extending below the substrate SUB. For example, as illustrated in FIG. 1A, the layout 10a may include patterns (e.g., M11) extending in a front-side wiring layer (e.g., M1) above the substrate SUB as well as patterns (e.g., BM11) extending in a backside wiring layer (e.g., BM1) below the substrate SUB. According to example embodiments, patterns extending below the substrate SUB may be utilized to supply power to the devices. These backside patterns that are used to supply power to the devices may be referred to as backside power rails. Routing resources may increase in the front-side wiring layer due to the patterns extending below the substrate SUB, and the integrated circuit may have a reduced area and/or an area-efficient structure. Especially, when the backside patterns are used for power supply, a supply voltage which is not dropped may be supplied to the devices due to a reduction of a voltage drop (IR drop).

Referring to FIG. 1A, the layout 10a may include gates (or gate electrodes) which extend in a Y-axis direction, and may also include active patterns APs which extend in an X-axis direction. For example, as illustrated in FIG. 1A, p-channel field effect transistor (PFET) active patterns and n-channel field effect transistor (NFET) active patterns may extend in the X-axis direction and may cross with the gates extending in the Y-axis direction. A source/drain SD may be formed on opposite ends of the gate, and a channel may be formed between the sources/drains SDs. A first backside pattern BM11 and a second backside pattern BM12 may extend in the X-axis direction in a first backside wiring layer BM1, and a backside interlayer dielectric (BILD) may be disposed between the first backside pattern BM11 and the second backside pattern BM12 in the first backside wiring layer BM1. According to example embodiments, the first backside pattern BM11 may provide a positive supply voltage to the PFETs, and the second backside pattern BM12 may provide a negative supply voltage to the NFETs.

The layout 10a may include a through silicon via TSV which passes through the substrate SUB between the first backside wiring layer BM1 and source/drain SD. For example, as illustrated in FIG. 1A, a first through silicon via TVS1 may extend from an upper surface of the first backside pattern BM11 to a bottom surface of a first source/drain SD1. Accordingly, the first source/drain SD1 may be electrically connected to the first backside pattern BM11 through the first through silicon via TSV1. Also, a second through silicon via TSV2 may extend from an upper surface of a second backside pattern BM12 to a bottom surface of a second source/drain SD2. Accordingly, the second source/drain SD2 may be electrically connected to the second backside pattern BM12 through the second through silicon via TSV2. Each of the first through silicon via TSV1 and the second through silicon via TSV2 in contact with the bottom surface of the source/drain SD may be referred to as a backside contact (BC). According to example embodiments, unlike what is illustrated in FIG. 1A, the backside contact may be disposed between the through silicon via and the source/drain.

A first pattern M11 of the first wiring layer M1 may be connected to the second source/drain SD2 through a first contact CA1. Herein, the front-side wiring layer may be referred to as a wiring layer and a pattern disposed in the front-side wiring layer may be referred to as a pattern, for brevity. A contact that is in contact with the upper surface of a source/drain, such as the first contact CA1, may be referred to as a frontside contact or simply as a contact. In addition, the frontside contact which is in contact with an upper surface of the gate and bottom surface of the front-side pattern of the first wiring layer M1 may be disposed on the gate, and the front-side pattern of the first wiring layer M1 may be connected to the gate through the frontside contact.

Referring to FIG. 1B, the layout 10b may include gates extending in the Y-axis direction and active patterns extending in the X-axis direction. The first backside pattern BM11 and the second backside pattern BM12 may extend in the X-axis direction in a backside wiring layer BM1. The first through silicon via TSV1 may extend between the first backside pattern BM11 and the first source/drain SD1, and the second through silicon via TSV2 may extend between the second backside pattern BM12 and the second source/drain SD2. Unlike the layout 10a of FIG. 1A, the layout 10b of FIG. 1B may have a via disposed between the first wiring layer M1 and the front-side contact. For example, as illustrated in FIG. 1B, the first contact CA1 may be disposed on the second source/drain SD2, and a first via VO1 of a via layer VO may be disposed between the first contact CA1 and the first pattern M11. In addition, the front-side contact may be disposed on the gate, and the via of the via layer V0 may be disposed between the front-side contact and the front-side pattern. Hereinafter, a structure including a via between the contact and the first wiring layer, such as the layout 10b of FIG. 1B, will be described primarily, however, example embodiments are not limited thereto. According to example embodiments, like the layout 10a of FIG. 1A, a contact on the gate (that is, a gate contact) and a contact on the source/drain (that is, a source/drain contact) may be in contact with the bottom surface of the front-side pattern of the first front-side wiring layer M1, and the via layer VO may be omitted. According to example embodiments, like the layout 10b of FIG. 1B, while the source/drain contact on the source/drain is connected to the front-side pattern of the first wiring layer M1 through the via layer V0, the gate contact on the gate may be in contact with the bottom surface of the front-side pattern of the first wiring layer M1 without the via of the via layer VO therebetween.

A pattern of the wiring layer may extend along a predetermined track. For example, the first pattern M11 of FIGS. 1A and 1B may extend in the X-axis direction along a first track T11 which extends in the X-axis direction in the first wiring layer M1. A track for patterns may be defined based on a minimum width of the patterns in the wiring layer, a spacing between the patterns, and/or the like. As a number of tracks increases in the integrated circuit, the routing resources may increase and routing congestion may be reduced. As described hereinafter with reference to the drawings, a number of available tracks may increase in the integrated circuit, resulting in increased routing resources. In addition, signal paths may be shortened as a result of improved routing efficiency, thereby improving performance and reliability of the integrated circuit. Also, an area required for routing may be reduced or eliminated, and as a result, an area occupied by the integrated circuit may be reduced.

FIG. 2A, 2B, 2C, and 2D illustrate examples of a device according to example embodiments. For example, FIG. 2A illustrates a fin field-effect transistor (FinFET) 20a, FIG. 2B illustrates a gate-all-round field effect transistor (GAAFET) 20b, FIG. 2C illustrates a multi-bridge channel field effect transistor (MBCFET) 20c, and FIG. 2D illustrates a vertical field effect transistor (VFET) 20d. For brevity of illustration, FIGS. 2A, 2B, and 2C illustrate one of two source/drain regions being removed, and FIG. 2D illustrates a cross-sectional view of VFET 20d cut by a plane parallel to a plane having the Y-axis and the Z-axis and passing through a channel CH of the VFET 20d.

Referring to FIG. 2A, the FinFET 20a may be formed by an active pattern in a fin shape which extends in the X-axis direction among shallow trench isolations (STIs), and a gate G which extends in the Y-axis direction. A source/drain SD may be formed on each of opposite sides of the gate G, and as a result, sources/drains may be spaced apart in the X-axis direction. An insulating film may be formed between the channel CH and the gate G. According to example embodiments, the FinFET 20a may be formed by a plurality of active patterns which are space apart from each other, and the gate G.

Referring to FIG. 2B, the GAAFET 20b may be formed by active patterns, that is, nanowires, spaced apart from each other in the Z-axis direction and extend in the X-axis direction, and the gate G which extends in the Y-axis direction. A source/drain SD may be formed on each of the opposite sides of the gate G, and as a result, sources/drains may be spaced apart in the X-axis direction. An insulating film may be formed between the channel CH and the gate G. The number of nanowires included in the GAAFET 20b is not limited to the number of nanowires illustrated in FIG. 2B.

Referring to FIG. 2C, the MBCFET 20c may be formed by active patterns, that is, nanosheets, which are spaced apart in the Z-axis direction and extend in the X-axis direction, and the gate G which extends in the Y-axis direction. The source/drain SD may be formed on the opposite sides of the gate G, and as a result, the source/drain may be spaced apart in the X-axis direction. An insulating film may be formed between the channel CH and the gate G. A number of nanosheets included in the MBCFET 20c is not limited to a number of nanosheets illustrated in FIG. 2C.

Referring to FIG. 2D, the VFET 20d may include a top source/drain T_SD and a bottom source/drain B_SD which are spaced apart in the Z-axis direction with the channel CH in between. The VFET 20d may include the gate G which surrounds the channel CH between the top source/drain T_SD and the bottom source/drain B_SD. An insulating film may be formed between the channel CH and the gate G.

Devices included in the integrated circuit are not limited to the examples shown in FIGS. 2A, 2B, 2C, and 2D. For example, the integrated circuit may include a ForkFET which has a structure in which the N-type transistors and P-type transistors have tighter spacing by dividing nanosheets for P-type transistors and nanosheets for N-type transistors with a dielectric wall. In addition, the integrated circuit may include a bipolar junction transistor in addition to a field effect transistor (FET), such as a complementary field effect transistor (CFET), negative capacitance field effect transistor (NCFET), and carbon nanotube (CNT) FET.

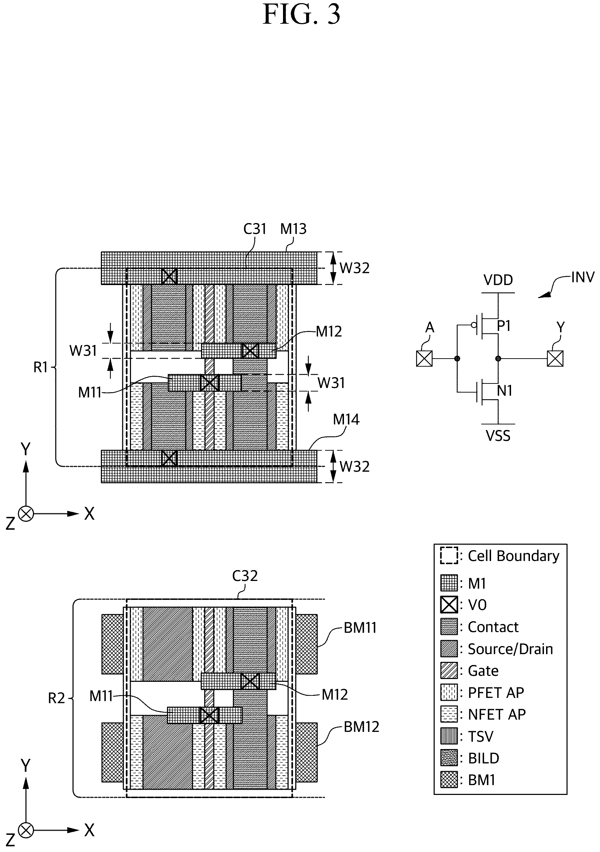

FIG. 3 illustrates a layout of an integrated circuit according to an example embodiment. For example, FIG. 3 illustrates an inverter circuit INV which is included in the integrated circuit, and a first cell C31 and second cell C32 corresponding to the inverter circuit INV. As illustrated in FIG. 3, the inverter circuit INV may output a signal through an output pin Y by inverting a signal received through an input pin A. The inverter circuit INV may include a PFET P1 and a NFET N1, and may receive a positive supply voltage VDD and a negative supply voltage VSS.

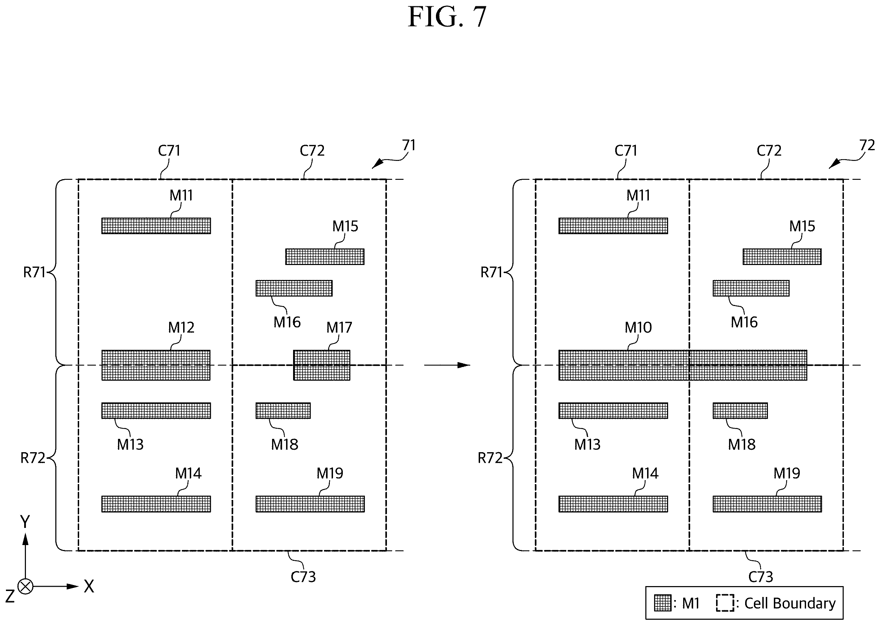

The integrated circuit may include cells. A cell may be referred to as a standard cell, as a unit of a layout included in the integrated circuit. The cell may include, for example, transistors, and may be designed to perform predefined functions. The cells may be placed to be arranged in a series of rows in the integrated circuit. For example, the cells may be placed to be arranged in a series of rows which extend in the X-axis direction. A cell placed in one row, such as the first cell C31 and the second cell C32 of FIG. 3, may be referred to as a single-height cell. In addition, a cell placed in two or more consecutive rows, such as a first cell C71 in FIG. 7, may be referred to as a multi-height cell. The integrated circuit may include patterns for supplying power to the cells. For example, the integrated circuit may include a power delivery network as the patterns for supplying power to the cells. The cells may receive the positive supply voltage VDD and negative supply voltage VSS from the power delivery network.

The first cell C31 may be placed in a first row R1 which extends in the X-axis direction, and the second cell C32 may be placed in a second row R2 which extends in the X-axis direction. Each of the first cell C31 and the second cell C32 may include active patterns extending in the X-axis direction and gates extending in the Y-axis direction. In addition, each of the first cell C31 and the second cell C32 may include a source/drain between gate electrodes, and may include a contact disposed on the source/drain. The gate may be connected to the first pattern M11 of the first wiring layer M1 through a contact (that is, the gate contact) and a via. Also, the source/drain may be connected to a second pattern M12 of the first wiring layer M1 through a contact (that is, the source/drain contact) and via. In each of the first cell C31 and the second cell C32, the first pattern M11 may correspond to the input pin A, and the second pattern M12 may correspond to the output pin Y. As described above with reference to FIGS. 1A and 1B, the first pattern M11 and the second pattern M12 may extend in the X-axis along tracks defined in the first wiring layer M1. As illustrated in FIG. 3, each of the first pattern M11 and the second pattern M12 may have a first width W31.

The first cell C31 may be supplied with power through a third pattern M13 and a fourth pattern M14 which extend in the X-axis direction along a boundary of the first row R1 in the first wiring layer M1. For example, the first cell C31 may receive the positive supply voltage VDD through the third pattern M13, and receive the negative supply voltage VSS through the fourth pattern M14. As illustrated in FIG. 3, each of the third pattern M13 and the fourth pattern M14 may have a second width W32. According to example embodiments, the second width W32 may be greater than the first width W31. A power delivery network that includes patterns of a front-side wiring layer such as the third pattern M13 and the fourth pattern M14 may be referred to as a frontside power delivery network (FSPDN).

The second cell C32 may be supplied with power through the first backside pattern BM11 and the second backside pattern BM12 which extend in the X-axis direction in the first backside wiring layer BM1. For example, the second cell C32 may receive the positive supply voltage VDD through the first backside pattern BM11, and receive the negative supply voltage VSS through the second backside pattern BM12. As illustrated in FIG. 3, the first backside pattern BM11 may extend below the PFET active pattern, and the second backside pattern BM12 may extend below the NFET active pattern. A power delivery network that includes patterns of a backside wiring layer, such as the first backside pattern BM11 and second backside pattern BM12, may be referred to as a backside power delivery network (BSPDN).

The second cell C32 may provide more routing resources than the first cell C31. For example, the third pattern M13 and the fourth pattern M14 for supplying power to the first cell C31 in the first wiring layer M1 may be omitted from the second cell C32, and as a result, tracks of the first wiring layer M1 corresponding to the third pattern M13 and the fourth pattern M14 may be used for routing in the second cell C32. As will be described hereinafter with reference to the drawings, the integrated circuit may include the backside power delivery network, and may include patterns disposed along boundaries of rows in the first wiring layer M1 and used for signal routing. Accordingly, the integrated circuit may have increased routing resources.

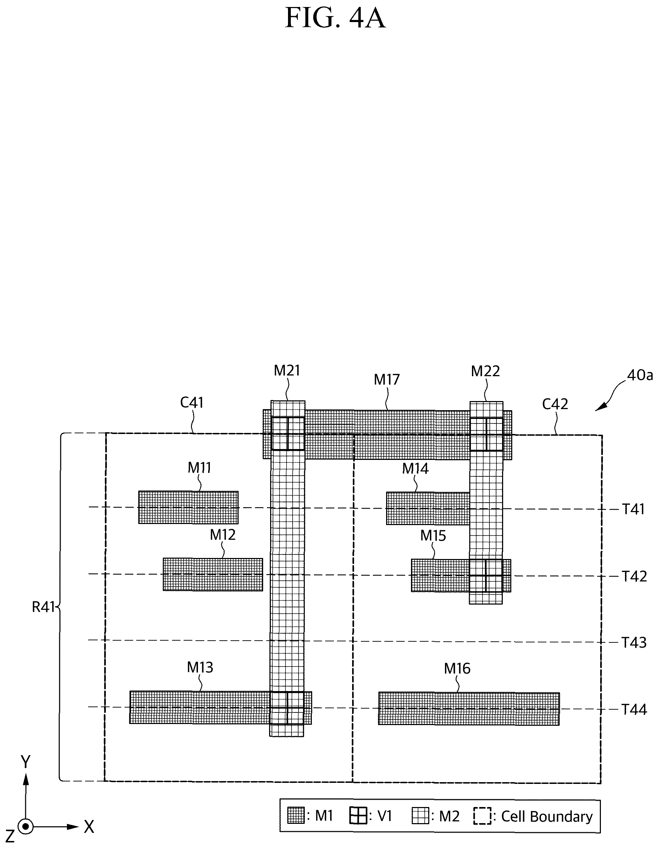

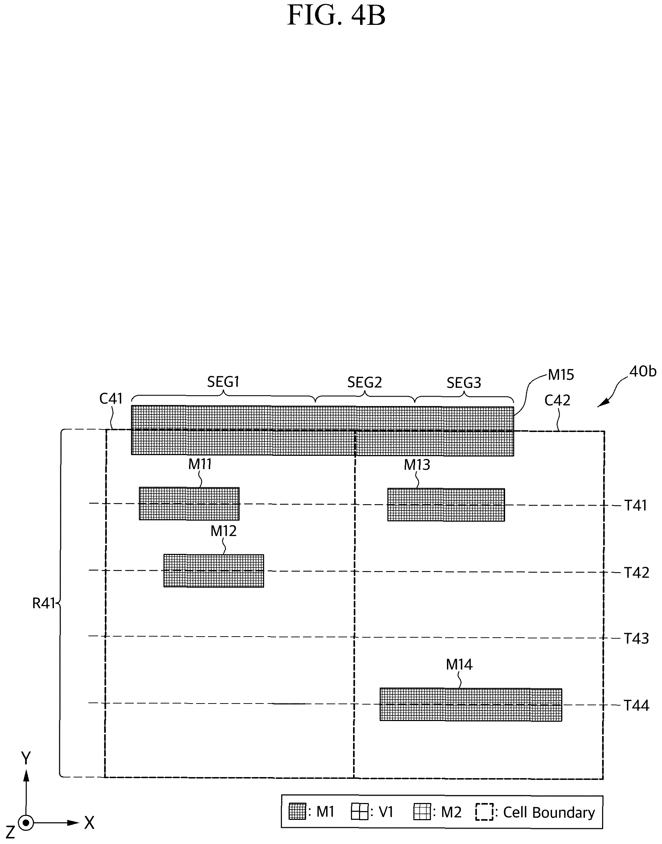

FIGS. 4A and 4B illustrate layouts of an integrated circuit according to example embodiments. For example, FIGS. 4A and 4B illustrate layouts 40a and 40b of the integrated circuit including a pattern extending along a boundary of a row. Hereinafter, redundant details in the descriptions of FIGS. 4A and 4B will be omitted.

Referring to FIG. 4A, the layout 40a may include a first cell C41 and a second cell C42 which are placed to be adjacent to each other in a first row R41. The first cell C41 may include the first to third patterns M11 to M13, each corresponding to pins in the first wiring layer M1, and similarly, the second cell C42 may include fourth to sixth patterns M14 to M16, each corresponding to the pins in the first wiring layer M1 as well. As illustrated in FIG. 4A, the first pattern M11 and the fourth pattern M14 may extend along a first track T41 in the X-axis direction, the second pattern M12 and the fifth pattern M15 may extend along a second track T42 in the X-axis direction, and the third pattern M13 and the sixth pattern M16 may extend along a fourth track T44 in the X-axis direction.

In FIG. 4A, the third pattern M13 may correspond to an output pin of the first cell C41, and the fifth pattern M15 may correspond to an input pin of the second cell C42. The second cell C42 may receive an output signal of the first cell C41, and accordingly, a seventh pattern M17 of the first wiring layer M1 which extends along a boundary of the first row R41 may be used to electrically connect the third pattern M13 to the fifth pattern M15. For example, as illustrated in FIG. 4A, the third pattern M13 may be connected to a first pattern M21 of a second wiring layer M2 through a via of a first via layer V1, and the first pattern M21 of the second wiring layer M2 may be connected to the seventh pattern M17 through the via of the first via layer V1. In addition, the fifth pattern M15 may be connected to a second pattern M22 of the second wiring layer M2 through the via of the first via layer V1, and the second pattern M22 of the second wiring layer M2 may be connected to the seventh pattern M17 through the via of the first via layer V1. Unlike what is illustrated in FIG. 4A, when the seventh pattern M17 is not used for electrically connecting the third pattern M13 to the fifth pattern M15, a pattern of the first wiring layer M1 which extends along a third track T43 may be used, and as a result, routing resources may decrease. According to example embodiments, as described above with reference to FIG. 3, a width of the seventh pattern M17 may be greater than a width of each of the first to sixth patterns M11 to M16.

Referring to FIG. 4B, the layout 40b may include the first cell C41 and the second cell C42 which are placed to be adjacent to each other in the first row R41. The first cell C41 of FIG. 4B may have the same function as the first cell C41 of FIG. 4A, and the second cell C42 of FIG. 4B may have the same function as the second cell C42 of FIG. 4A. The first cell C41 may include the first pattern M11 and second pattern M12 corresponding to pins of the first cell C41, and the second cell C42 may include the third pattern M13 and fourth pattern M14 corresponding to pins of the second cell C42. According to example embodiments, pins of the cells may be disposed on a boundary of a row, extending along a boundary of a row, and merged with pins of other cells. For example, as illustrated in FIG. 4B, the fifth pattern M15 may be disposed on the boundary of the first row R41, and the fifth pattern M15 may extend along the boundary of the first row R41.

The fifth pattern M15 may include first to third segments SEG1 to SEG3. The first segment SEG1 may correspond to the output pin of the first cell C41, and the third segment SEG3 may correspond to the input pin of the second cell C42. That is, the third pattern M13 and the fifth pattern M15 of FIG. 4A may be moved onto the boundary of the first row R41 in the layout 40b of FIG. 4B. The first segment SEG1 and the third segment SEG3 may be connected to each other through the second segment SEG2. The output pin of the first cell C41 and the input pin of the second cell C42 in the layout 40b of FIG. 4B may be connected to each other by merging the extending pins, and vias of the first via layer V1 and the first pattern M21 and second pattern M22 of the second wiring layer M2 in FIG. 4A may be omitted. In addition, a part of the second track T42 and the fourth track T44 may be used for routing in addition to the third track T43. Accordingly, the layout 40b may provide more routing resources than the layout 40a. In addition, a signal path between the output pin of the first cell C41 and the input pin of the second cell C42 in layout 40b may be shortened, which may lead to a decrease in signal delay, and as a result, the layout 40b may provide improved performance and reliability.

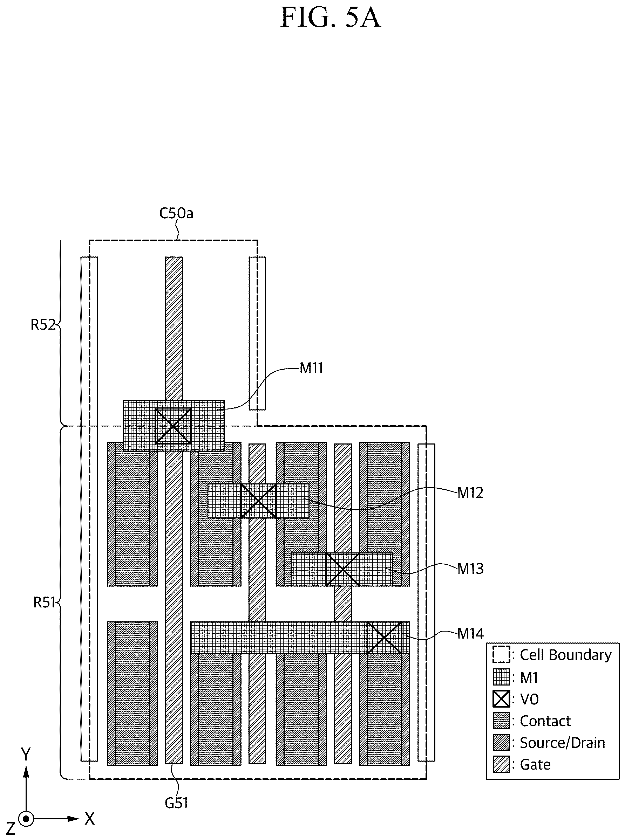

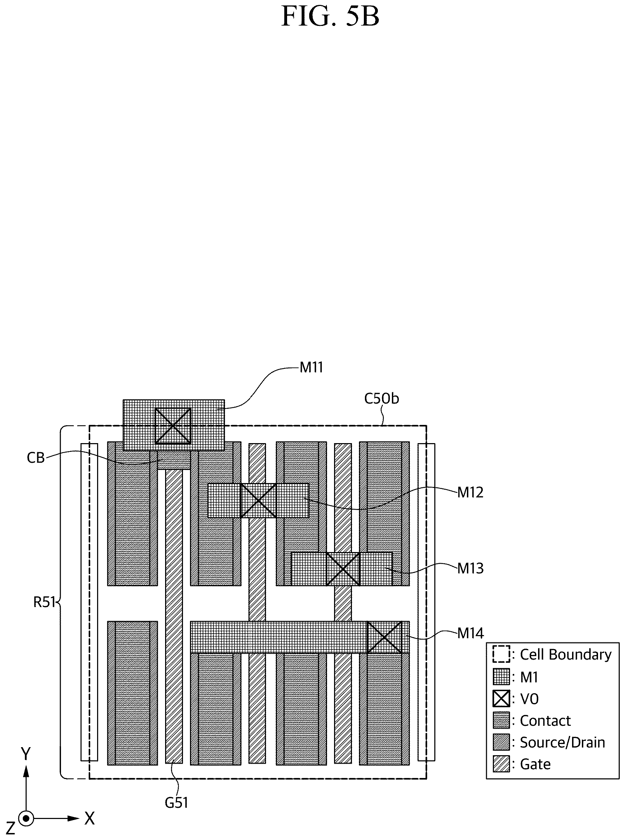

FIGS. 5A and 5B illustrate examples of a cell according to example embodiments. For example, FIGS. 5A and 5B illustrate cells C50a and C50b including an input pin disposed on a boundary of a row. Each of the cells C50a and C50b in FIGS. 5A and 5B may have three input pins and one output pin. According to example embodiments, as described with reference to FIGS. 1A and 1B, vias of the via layer VO may be omitted in FIGS. 5A and 5B, and the gate contact and source/drain contact may be directly connected to the bottom surface of the pattern of the first wiring layer M1. Also, according to example embodiments, the via of the via layer VO may be disposed between the source/drain contact and the first wiring layer M1, and the gate contact may be directly connected to the pattern of the first wiring layer M1 without the via of the via layer VO therebetween.

Referring to FIG. 5A, the cell C50a may include gates extending in the Y-axis direction. The cell C50a may include sources/drains disposed between the gates and source/drain contacts disposed on the sources/drains. The cell C50a may include the first to fourth patterns M11 to M14 extending in the X-axis direction in the first wiring layer M1. The first to third patterns M11 to M13 connected respectively to the gates may correspond to input pins of the cell C50a, and the fourth pattern M14 connected to the source/drain may correspond to the output pin of the cell C50a.

The first pattern M11 corresponding to the input pin of the cell C50a and connected to a first gate G51 may be disposed on a boundary between a first row R51 and a second row R52. As illustrated in FIG. 5A, the first gate G51 may extend in the Y-axis direction across the boundary between the first row R51 and the second row R52, and may be connected to the first pattern M11 through a gate contact disposed on the first gate G51. Accordingly, the cell C50a may have a shape that protrudes into the second row R52 as illustrated in FIG. 5A.

Referring to FIG. 5B, the cell C50b may include gates extending in the Y-axis direction. The cell C50b may include sources/drains disposed between the gates and source/drain contacts disposed on the sources/drains. The cell C50b may include first to fourth patterns M11 to M14 extending in the X-axis direction. The first to third patterns M11 to M13 connected respectively to the gates may correspond to the input pins of the cell C50b, and the fourth pattern M14 connected to the source/drain may correspond to the output pin of the cell C50b.

The first pattern M11 corresponding to the input pin of the cell C50b and connected to the first gate G51 may be disposed on the boundary of the first row R51. As illustrated in FIG. 5B, a gate contact CB may be disposed on the first gate G51, and may extend in the Y-axis direction across the boundary of the first row R51. The first pattern M11 may be connected to the first gate G51 through the extending gate contact CB. When comparing with the cell C50a of FIG. 5A, the gate contact CB instead of the first gate G51 may extend in the Y-axis direction, and the cell C50b may have the same height (that is, a length in the Y-axis direction) as the first row R51. According to example embodiments, unlike what is illustrated in FIG. 5B, the gate contact may be disposed within the boundary of the cell C50b, and the via of the via layer V0 on the gate contact may extend in the Y-axis direction across the boundary of the first row R51.

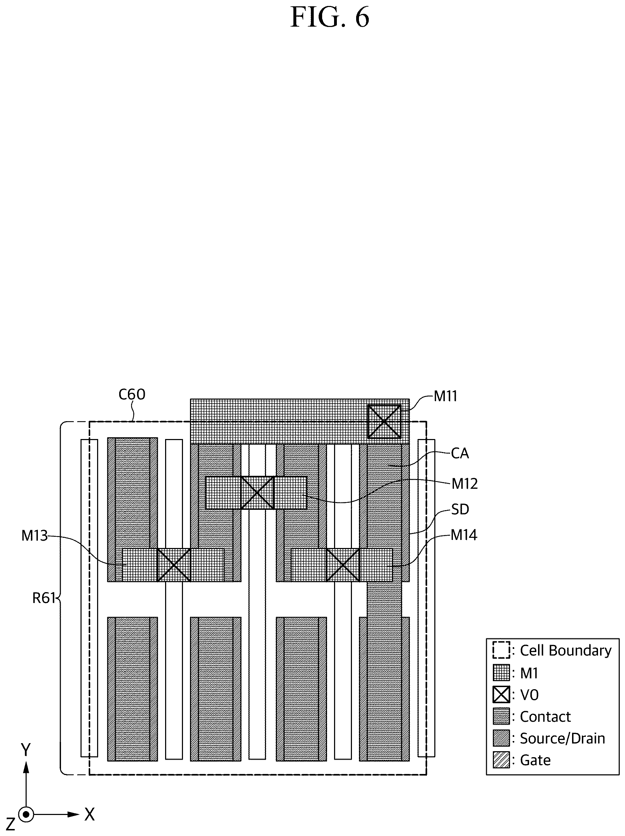

FIG. 6 illustrates a cell C60 according to an example embodiment. For example, FIG. 6 illustrates the cell C60 including an output pin disposed on a boundary of a row. The cell C60 of FIG. 6 may include three input pins and one output pin.

Referring to FIG. 6, the cell C60 may include gates extending in the Y-axis direction. The cell C60 may include sources/drains disposed between the gates and source/drain contacts disposed on the sources/drains. The cell C60 may include the first to fourth patterns M11 to M14 extending in the X-axis direction in the first wiring layer M1. The second to fourth patterns M12 to M14 connected respectively to the gates may correspond to input pins of the cell C60, and the first pattern M11 connected to the source/drain SD may correspond to the output pin of the cell C60.

The first pattern M11 corresponding to the output pin of the cell C60 and connected to the source/drain SD may be disposed on a boundary of a first row R61. As illustrated in FIG. 6, a source/drain contact CA may be disposed on the source/drain, and may extend in the Y-axis direction across the boundary of the first row R61. The first pattern M11 may be connected to the source/drain SD through the extending source/drain contact CA. Accordingly, the cell C60 may have the same height as the first row R61. According to example embodiments, unlike what is illustrated in FIG. 6, the source/drain contact may be disposed within a boundary of the cell C60, and the via of the via layer V0 on the source/drain contact may extend in the Y-axis direction across the boundary of the first row R61.

FIG. 7 illustrates a layout of an integrated circuit according to an example embodiment. For example, FIG. 7 illustrates a first layout 71 in which first to third cells C71 to C73 are placed, and a second layout 72 in which pins of the first to third cells C71 to C73 are routed.

Referring to FIG. 7, the first layout 71 may include the first to third cells C71 to C73. The first cell C71 may be placed consecutively in a first row R71 and a second row R72 as a multi-height cell. The second cell C72 may be disposed adjacent to the first cell C71 in the first row R71 as a single-height cell, and the third cell C73 may be disposed adjacent to the first cell C71 in the second row R2 as a single-height cell. The first cell C71 may include first to fourth patterns M11 to M14 extending in the X-axis direction in the first wiring layer M1, and the first to fourth patterns M11 to M14 may correspond to the pins of the first cell C71. The second cell C72 may include the fifth pattern M15 and sixth pattern M16 extending in the X-axis direction in the first wiring layer M1, and the fifth pattern M15 and sixth pattern M16 may correspond to the pins of the second cell C72. The third cell C73 may include seventh to ninth patterns M17 to M19 extending in the X-axis direction in the first wiring layer M1, and the seventh to ninth patterns M17 to M19 may correspond to pins of the third cell C73. It is to be assumed that the second pattern M12 and the seventh pattern M17 in FIG. 7 correspond to the same node (or net) in the integrated circuit.

A multi-height cell may include a pin extending along a boundary between rows within the multi-height cell. For example, as illustrated in FIG. 7, the second pattern M12 may extend in the X-axis direction along a boundary between the first row R71 and the second row R72 within the first cell C71. According to example embodiments, as described with reference to FIG. 3, a width of the second pattern M12 (that is, a length in the Y-axis direction) may be greater than that of another pin, such as a width of the first pattern M11. According to example embodiments, similar to that of the cell C50a of FIG. 5A, when the second pattern M12 corresponds to an input pin of the first cell C71, the first cell C71 may include gates extending in the Y-axis direction across the boundary between the first row R71 and the second row R72, and the second pattern M12 may be connected to the extending gate. According to example embodiments, similar to that of the cell C60 of FIG. 6, when the second pattern M12 corresponds to an output pin of the first cell C71, the first cell C71 may include a source/drain contact extending in the Y-axis direction across the boundary between the first row R71 and the second row R72, and the second pattern M12 may be connected to the extending source/drain contact.

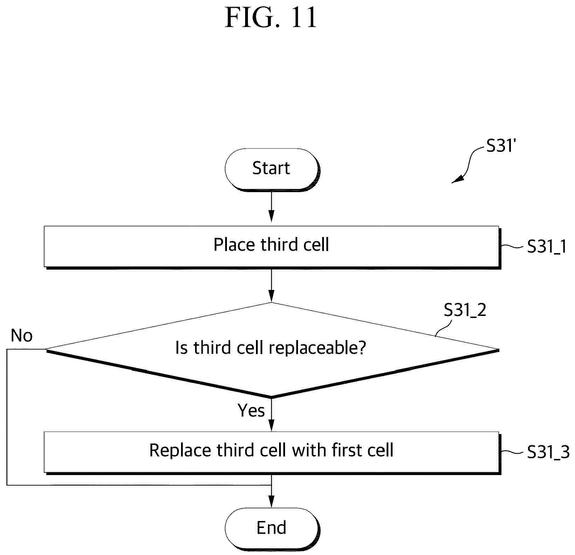

The second cell C72 may include pins which are spaced apart from the pin of the third cell C73, that is, the seventh pattern M17, which is disposed on a boundary of a row. For example, as illustrated in FIG. 7, the fifth pattern M15 and sixth pattern M16 may be spaced apart from the seventh pattern M17 in the Y-axis direction. The second cell C72 disposed adjacent to the third cell C73 may not include a pin disposed on a boundary, as will be described later with reference to FIG. 11. In addition, a cell may be placed such that a pin disposed on the boundary is spaced apart by at least a minimum distance from the seventh pattern M17 of the third cell.

Referring to FIG. 7, pins of the first to third cells C71 to C73 may be routed in the second layout 72. According to example embodiments, the pin of the first cell C71 and the pin of the third cell C73 may extend along a boundary and be merged. For example, as illustrated in FIG. 7, the second pattern M12 of the first cell C71, and the seventh pattern M17 of the third cell C73 may extend in the X-axis direction in the second layout 72 and be merged as a pattern M10. Accordingly, as described above with reference to FIG. 4B, the second layout 72 may provide increased routing resources and a shortened signal path.

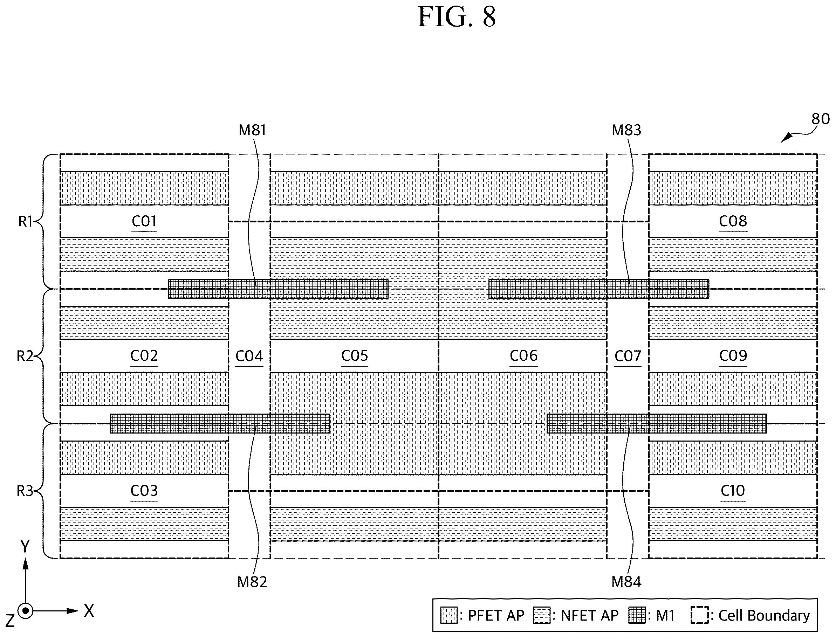

FIG. 8 illustrates a layout 80 of an integrated circuit according to an example embodiment. As illustrated in FIG. 8, the layout 80 may include first to tenth cells C01 to C10 placed in first to third rows R1 to R3. The first to third cells C01 to C03 and the eighth to tenth cells C08 to C10 may be single-height cells, and the fifth cell C05 and sixth cell C06 may be multi-height cells.

As described above with reference to FIG. 3, the cells may include the PFET active pattern and the NFET active pattern extending in the X-axis direction. For example, the first cell C01, as a single-height cell, may include the PFET active pattern and the NFET active pattern which extend parallel to each other in the X-axis direction in the first row R1. Each of the fifth cell C05 and the sixth cell C06 may include the NFET active pattern extending in the X-axis direction along a boundary between the first row R1 and the second row R2, and the PFET active pattern extending in the X-axis direction along a boundary between the second row R2 and the third row R3.

As illustrated in FIG. 8, the PFET active pattern (or NFET active pattern) included in each of the fifth cell CO5 and the sixth cell C06 may have a width greater than a width (that is, the length in the Y-axis direction) of the PFET active pattern (or NFET active pattern) of a single-height cell. A width of a channel may increase as a width of an active pattern increases, and this may result in increased current driving capacity and operational speed of a transistor. Accordingly, while a single-height cell such as the first cell C01 may be placed when low power is required, a multi-height cell including an active pattern with an extending width, such as the fifth cell C05, may be placed when high operational speed is required (e.g., critical path). As a result of having active patterns with different widths, the fourth cell C04 may be placed between single-height cells (that is, C01 to C03) and the fifth cell C05, and the seventh cell C07 may be placed between single-height cells (that is, C08 to C10) and the sixth cell C06. The fourth cell C04 and the seventh cell C07 may be referred to as filler cells.

As described with reference to FIG. 7, the fifth cell C05 and/or the sixth cell C06 may include a pin extending on a boundary between rows, and the extending pin may be merged with a pin of another cell. For example, as illustrated in FIG. 8, a first pattern M81 may extend along a boundary between the first row R1 and the second row R2, and a pin of the first cell C01 or the second cell C02 and a pin of the fifth cell CO5 may correspond to the merged pin. A second pattern M82 may extend in the X-axis direction along a boundary between the second row R2 and the third row R3, and a pin of the second cell C02 or the third cell C03 and a pin of the fifth cell C05 may correspond to the merged pin. In addition, a third pattern M83 may extend in the X-axis direction along the boundary between the first row R1 and the second row R2, and a pin of the eight cell C08 or ninth cell C09 and a pin of the sixth cell C06 may correspond to the merged pin. A fourth pattern M84 may extend in the X-axis direction along the boundary between the second row R2 and the third row R3, and a pin of the ninth cell C09 or tenth cell C10 and a pin of sixth cell C06 may correspond to the merged pin.

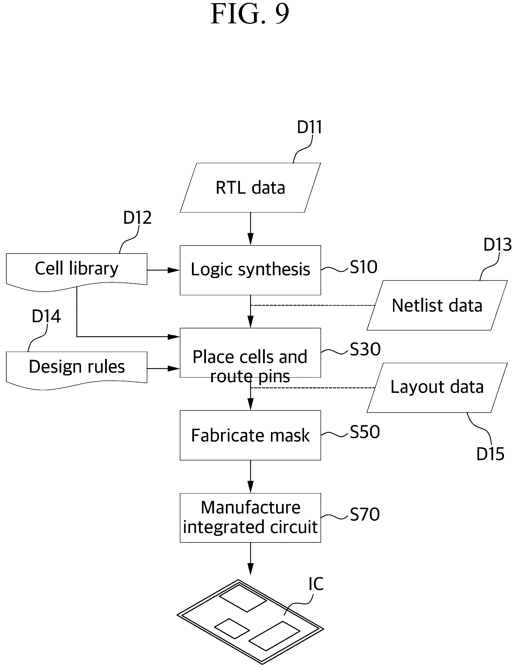

FIG. 9 is a flowchart illustrating a method of manufacturing an integrated circuit (IC) according to an example embodiment. Specifically, the flowchart of FIG. 9 illustrates an example method of manufacturing an integrated circuit (IC) including cells. As illustrated in FIG. 9, the method of manufacturing an integrated circuit (IC) may include a number of operations S10, S30, S50, and S70.

A cell library (or a standard cell library) D12 may include information on the cells, such as information on functions, characteristics, layouts, and/or the like. According to example embodiments, the cell library D12 may define cells corresponding to the same function and each corresponding to different layouts. For example, the cell library D12 may define a first cell and a second cell which correspond to the same function, and the first cell may include pins within a boundary, whereas the second cell may include at least one pin extending along a boundary of a row. As described with reference to the drawings, a pin extending along a boundary of a row may be merged with a pin of another cell.

Design rules D14 may include requirements that a layout of an integrated circuit should comply with. For example, the design rules D14 may include requirements on spacing between patterns on the same layer, a minimum width of a pattern, a routing direction of a wiring layer, and/or the like. According to example embodiments, the design rules D14 may define a minimum width of an active pattern, a minimum spacing between active patterns, etc.

In operation S10, a logic synthesis for generating netlist data D13 from register transfer level (RTL) data D11 may be performed. For example, a semiconductor designing tool (e.g., logic synthesis tool) may generate the netlist data D13 including a bitstream or a netlist by performing logic synthesis by referencing the cell library D12 from the RTL data D11 which is written using a hardware description language (HDL), such as very high speed integrated circuit (very high speed integrated circuit, VHSIC) hardware description language (VHSIC hardware description language, VHDL) and Verilog. The netlist data D13 may correspond to an input of a place and a route which will be described later. Herein, the netlist data D13 may be referred to as input data.

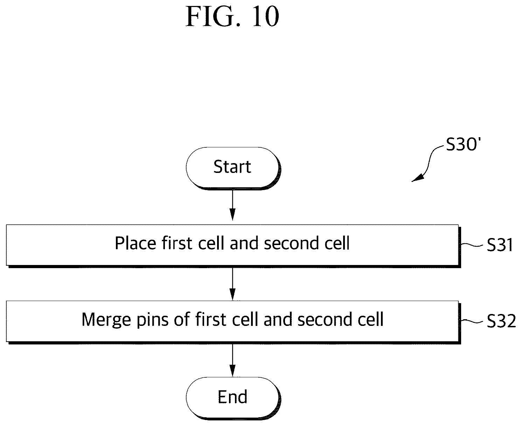

In operation S30, cells may be placed and pins may be routed. For example, the semiconductor designing tool (e.g., P&R tool) may place cells used in the netlist data D13 by referencing the cell library D12 and design rules D14. According to example embodiments, the semiconductor designing tool may dispose backside patterns in a backside wiring layer. Pins of the placed cells may be routed. For example, the semiconductor designing tool may generate interconnections that electrically connect output pins and input pins of the placed cells. The semiconductor designing tool may move the placed cells and/or replace the placed cells with cells of another layout while routing the pins. In addition, the semiconductor designing tool may generate interconnections connected to nodes to which positive supply voltage is supplied and/or nodes to which negative supply voltage is applied, to provide power to function cells. The interconnection may include a via of a via layer and/or a pattern of a wiring layer. The semiconductor designing tool may generate layout data D15 that defines placed cells and generated interconnections, namely, the layout of the integrated circuit (IC). The layout data D15 may have a format, such as the GDSII format, and may include geometric information on cells and interconnections. The semiconductor designing tool may reference the design rules D14 while routing the pins of the cells. The layout data D15 may correspond to an output of a place and a route, and may be referred to as output data herein. Operation S30 may refer to a method of designing the integrated circuit. An example of operation S30 will be described with reference to FIG. 10.

In operation S50, an operation of fabricating a mask may be performed. For example, optical proximity correction (OPC) for correcting distortion such as refraction of light which is caused by characteristics of light during photolithography process may be applied to the layout data D15. Patterns on the mask may be defined to form patterns disposed in a plurality of layers based on data which OPC is performed, and at least one mask (or, photomask) for forming patterns of each of a plurality of layers may be fabricated. According to example embodiments, the layout of the integrated circuit (IC) may be modified restrictively in operation S50, and the restrictive modification of the integrated circuit (IC) may be referred to as design polishing, as a post-processing operation for optimizing the integrated circuit (IC) structure.

In operation S70, a process of manufacturing the integrated circuit (IC) may be performed. For example, the integrated circuit (IC) may be manufactured by patterning the plurality of layers using the at least one mask fabricated in operation S50. A front-end-of-line (FEOL) may include planarizing and cleaning a wafer, forming a trench, forming a well, forming a gate electrode, and forming a source/drain. Individual devices such as transistors, capacitors, and resistors may be formed on the substrate by the FEOL. In addition, a back-end-of-line (BEOL) may include siliciding a gate and source and drain region, adding a dielectric, planarizing, forming a hole, adding a metal layer, forming a via, forming a passivation layer, and/or the like. Individual devices such as transistors, capacitors, and resistors may be connected to each other by the BEOL. According to example embodiments, a middle-of-line (MOL) may be performed between the FEOL and the BEOL, and contacts may be formed on the individual devices. Then, the integrated circuit (IC) may be packaged into a semiconductor package, and may be used as a component of various types of applications.

FIG. 10 is a flowchart illustrating a method of designing an integrated circuit according to an example embodiment. For example, the flowchart of FIG. 10 illustrates an example of operation S30 of FIG. 9. As described above with reference to FIG. 9, cells may be placed and pins may be routed in operation S30' of FIG. 10. As illustrated in FIG. 10, operation S30' may include operations S31 and S32.

Referring to FIG. 10, the first cell and the second cell may be placed in operation S31. For example, the semiconductor designing tool may place the first cell and the second cell into the same row. As described above with reference to the drawings, each of the first cell and the second cell may have a pin extending along a boundary of a row. According to example embodiments, a width of a pin extending along a boundary of a row may be greater than or equal to a width of a pin extending within a boundary of a cell. The first cell and the second cell may each be a single-height cell or a multi-height cell. In addition, the first cell and the second cell may be adjacent to each other or another cell may be placed between the first cell and the second cell. An example of operation S31 will be described with reference to FIG. 11.

In operation S32, pins of the first cell and the second cell may be merged. For example, the semiconductor designing tool may merge pins by extending the pins in the first cell and the second cell, which are placed in operation S31 on the boundary of the row. Accordingly, the pin of the first cell and the pin of the second cell may be connected to each other without using additional routing resources, such as a via and a pattern of other wiring layer. As a result, routing resources may increase and a signal path may be shortened.

FIG. 11 is a flowchart illustrating a method of designing an integrated circuit according to an example embodiment. For example, the flowchart of FIG. 11 illustrates an example of operation S31 of FIG. 10. As described with reference to FIG. 10, the first cell and the second cell may be placed in operation S31' of FIG. 11. As illustrated in FIG. 11, operation S30' may include a number of operations S31_1 to S31_3. FIG. 11 will be described with reference to FIG. 9 and FIG. 10.

Referring to FIG. 11, a third cell may be placed in operation S31_1. For example, the semiconductor designing tool may place the third cell including pins within the boundary of the cell. As described above with reference to FIG. 9, the cell library may define cells providing the same function but having different layouts. The semiconductor designing tool may place the third cell including pins within the boundary of the cell among cells available in the cell library based on identified cells in the RTL data D11.

In operation S31_2, whether or not the third cell is replaceable may be determined. For example, the semiconductor designing tool may determine whether the third cell placed in operation S31_1 can be replaced with the first cell that has the same function as the third cell but has a different layout. As described with reference to FIG. 10, the first cell may include a pin extending along the boundary between the first row and the second row which is adjacent to the first row. When a fourth cell placed adjacent to the third cell, that is, the fourth cell placed in the second row adjacent to the first row in which the third cell is placed, has a pin extending along the boundary between the first row and the second row, and when the pin of the first cell and the pin of the fourth cell are overlapped or do not comply with the minimum spacing defined by the design rules D14, the semiconductor designing tool may determine that the third cell is not replaceable with the first cell. Alternatively, when the fourth cell does not include a pin extending along the boundary between the first row and the second row, the semiconductor designing tool may determine that the third cell is replaceable with the first cell. Also, when the pin of the first cell and the pin of the fourth cell comply with the minimum spacing defined by the design rules D14, the semiconductor designing tool may determine that the third cell is replaceable with the first cell even if the fourth cell has a pin extending along the boundary between the first row and the second row.

When it is determined that the third cell is replaceable, the third cell may be replaced with the first cell in operation S31_3. For example, the semiconductor designing tool may replace the third cell with the first cell when the third cell is determined to be replaceable with the first cell in operation S31_2. Accordingly, a pin extending along the boundary of a row may be disposed or may be merged with the pin of the second cell of FIG. 10 which is placed in the same row.

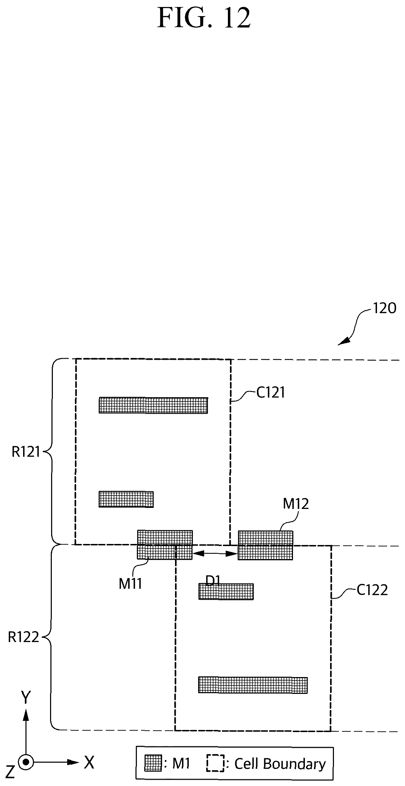

FIG. 12 illustrates a layout 120 of an integrated circuit according to an example embodiment. As illustrated in FIG. 12, the layout 120 may include a first cell C121 placed in a first row R121 and a second cell C122 placed in a second row R122.

According to example embodiments, cells with pins placed on the boundaries of rows may be placed adjacent to each other in rows close to each other. For example, when the second cell C122 including the second pattern M12 is placed while the first cell C121 including a pin disposed on a boundary between the first row R121 and the second row R122, namely, the first pattern M11, is placed, the semiconductor designing tool may place the second cell C122 such that the first pattern M11 and the second pattern M12 are spaced apart by a minimum distance D1 or more. According to example embodiments, the first pattern M11 and the second pattern M12 may correspond to the same net in the integrated circuit and may each extend and be merged with each other. According to example embodiments, the first pattern M11 and the second pattern M12 may each correspond to different nets in the integrated circuit.

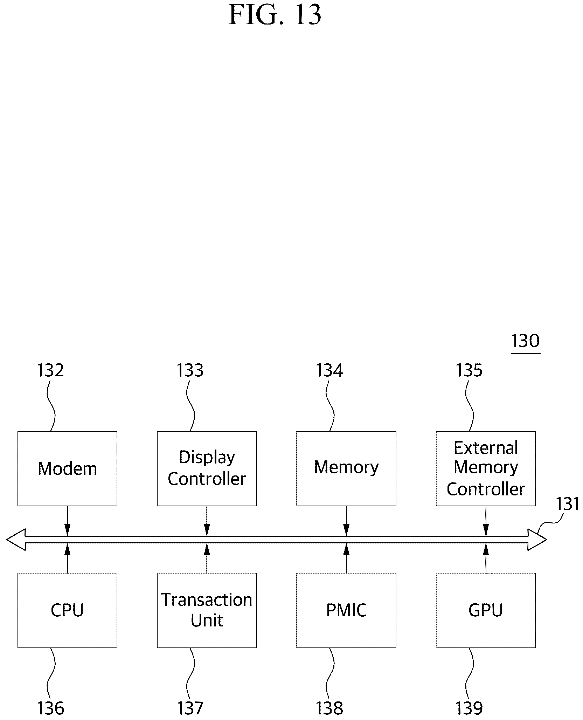

FIG. 13 is a block diagram illustrating a system-on-chip (SoC) 130 according to an example embodiment. The system-on-chip 130 is a semiconductor device which may include the integrated circuit according to an example embodiment. The system-on-chip 130, in which complicated blocks, such as intellectual properties (IPs) performing various functions, are implemented in a single chip, may be designed using a method of designing the integrated circuit according to example embodiments, and the system-on-chip 130 may have a reduced space and improved performance and reliability as a result of increased routing resources and a shortened signal path. Referring to FIG. 13, the system-on-chip 130 may include a modem 132, a display controller 133, a memory 134, an external memory controller 135, a central processing unit (CPU) 136, a transaction unit 137, a power management integrated circuit (PMIC) 138, and a graphic processing unit (GPU) 139, and each functional block of the system-on-chip 130 may communicate with each other through a system bus 131.

The CPU 136 that is capable of controlling operations of the system-on-chip 130 may control operations of other functional blocks 132 to 139. The modem 132 may demodulate a signal received outside of the system-on-chip 130 or modulate a signal generated within the system-on-chip 130. The external memory controller 135 may control a process of receiving and/or transmitting data from and/or to the external memory device connected to the system-on-chip 130. For example, a program and/or data stored in the external memory device may be forwarded to the CPU 136 or GPU 139 under control of the external memory controller 135. The GPU 139 may execute program instructions related to graphic processing. The GPU 139 may receive graphic data through the external memory controller 135 and may transmit processed graphic data outside the system-on-chip 130 through the external memory controller 135. The transaction unit 137 may monitor data transactions of each functional block and the PMIC 138 may control power supplied to each functional block under control of the transaction unit 137. The display controller 133 may transmit data generated within the system-on-chip 130 by controlling a display (or display device) outside the system-on-chip 130. The memory 134 may include a non-volatile memory such as an electrically erasable programmable read-only memory (EEPROM) and a flash memory, and may include a volatile memory such as a dynamic random-access memory (DRAM) and a static random-access memory (SRAM).

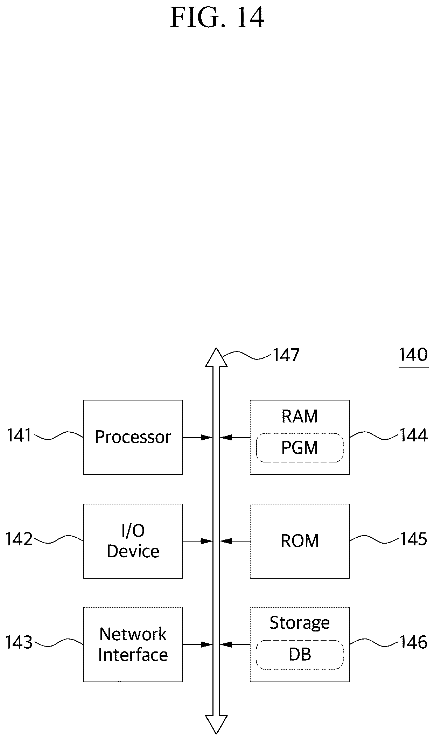

FIG. 14 is a block diagram illustrating a computing system 140 including a memory for storing a program according to an example embodiment. The method of designing the integrated circuit according to an example embodiment, that is, at least one of the operations included in the flowchart described above, for example, may be executed by the computing system (or a computer) 140.

The computing system 140 may be a fixed (or stationary) type of a computing system, such as a desktop computer, workstation and server, or a portable computing system, such as a laptop computer. As illustrated in FIG. 14, the computing system 140 may include a processor 141, an input/output device 142, a network interface 143, a random access memory (RAM) 144, a read-only memory (ROM) 145, and a storage 146. The processor 141, the input/output devices 142, the network interface 143, the RAM 144, the ROM 145, and the storage 146 may be connected to a bus 147, and may communicate with each other through the bus 147.

The processor 141 may be referred to as a processing unit, and may include at least one core for executing a random instruction set (e.g., Intel-Architecture-32 (IA-32), 64-bit extension IA-32, x86-64, PowerPC, Sparc, MIPS, ARM, IA-64, etc.), such as a microprocessor, application processor (AP), digital signal processor (DSP), and graphic processing unit (GPU). For example, the processor 141 may access a memory, that is, the RAM 144 and the ROM 145, and/or execute instructions stored in the RAM 144 and the ROM 145 through the bus 147.

The RAM 144 may store a program PGM for the method of designing the integrated circuit according to an example embodiment or at least a part of the program PGM, and the program PGM may allow the processor 141 to execute the method of designing the integrated circuit, that is, at least one of the operations included in the method of FIG. 9, for example. In other words, the program PGM may include a number of instructions which may be executed by the processor 141, and the instructions included in the program PGM may allow the processor 141 to execute at least one of the operations included in the flowcharts described above.

The storage 146 may not lose data stored even when the power supplied to the computing system 140 is blocked. For example, the storage 146 may include a non-volatile memory device or may include a storage medium such as a magnetic tape, an optical disc, and a magnetic disc. In addition, the storage 146 may be detachable from the computing system 140. The storage 146 may store the program PGM according to example embodiments of the present disclosure, and the program PGM or at least a part of the program PGM may be loaded to the RAM 144 before the program PGM is executed by the processor 141. Alternatively, the storage 146 may store a file written in a programming language, and a program generated from the file via compiler, for example, or at least a part thereof, may be loaded to the RAM 144. In addition, as illustrated in FIG. 14, the storage 146 may store a database DB, and the database DB may include information required for designing the integrated circuit, such as information on designed blocks, the cell library D12 of FIG. 9, and/or the design rules D14 of FIG. 9.

The storage 146 may store data to be processed by the processor 141 or data processed by the processor 141. That is, the processor 141 may generate data by processing data stored in the storage 146 based on the program PGM, and may store the generated data into the storage 146. For example, the storage 146 may store the RTL data D11, netlist data D13, and/or layout data D15 of FIG. 9.

The input/output devices 142 may include an input device, such as a keyboard and a pointing device, and may also include an output device, such as a display device and a printer. For example, users may trigger execution of the program PGM by the processor 141 through the input/output devices 142, may input the RTL data D11 and/or the netlist data D13 of FIG. 9, and may check the layout data D15 of FIG. 9.

The network interface 143 may provide an access for a network outside the computing system 140. For example, the network may include a number of computing systems and communication links, and the communication links may include wired links, optical links, wireless links, and other types of links.

According to an aspect of an example embodiment of the present disclosure, there is provided a method of designing an integrated circuit including a plurality of cells, the method including placing a plurality of cells and routing pins of the plurality of cells, wherein the placing the plurality of cells and the routing pins of the plurality of cells include: placing a first cell including a first pin which extends in a first direction along a boundary between a first row and a second row, which are adjacent to each other and extending in the first direction; placing a second cell including a second pin which extends in the first direction along the boundary between the first row and the second row; and generating a first pattern by merging the first pin and the second pin in a first wiring layer on a substrate.

The placing the first cell and the placing the second cell may include the placing the first cell and the second cell each including: a device on the substrate; a backside pattern extending in the first direction below the substrate and configured to provide a supply voltage to the first cell and the second cell; and a backside contact between the device and the backside pattern.

The placing the first cell may include placing the first cell, which includes a third pin extending in the first direction in the first wiring layer, a width of the first pattern being greater than a width of the third pin of the first cell.

The placing the plurality of cells and the routing pins of the plurality of cells may further include placing a third cell, which includes at least one fourth pin, adjacent to the first cell in the second row, and wherein the at least one fourth pin of the third cell is apart from the first pattern.

The placing the first cell may include placing a fourth cell which provides an identical function as the first cell; and replacing the fourth cell with the first cell based on determining that the fourth cell is replaceable with the first cell.

The method may further include obtaining at least one mask which is fabricated based on the output data; and manufacturing the integrated circuit based on the at least one mask.

At least one of the components, elements, modules or units (collectively "components" in this paragraph) represented by a block in the drawings, may be embodied as various numbers of hardware, software and/or firmware structures that execute respective functions described above, according to one or more example embodiments. For example, at least one of these components may use a direct circuit structure, such as a memory, a processor, a logic circuit, a look-up table, etc. that may execute the respective functions through controls of one or more microprocessors or other control apparatuses. Also, at least one of these components may be specifically embodied by a module, a program, or a part of code, which contains one or more executable instructions for performing specified logic functions, and executed by one or more microprocessors or other control apparatuses. Further, at least one of these components may include or may be implemented by a processor such as a central processing unit (CPU) that performs the respective functions, a microprocessor, or the like. Two or more of these components may be combined into one single component which performs all operations or functions of the combined two or more components. Also, at least part of functions of at least one of these components may be performed by another of these components. Further, although a bus is not illustrated in the above block diagrams, communication between the components may be performed through the bus. Functional aspects of the above example embodiments may be implemented in algorithms that execute on one or more processors. Furthermore, the components represented by a block or processing steps may employ any number of related art techniques for electronics configuration, signal processing and/or control, data processing and the like.

As described above, example embodiments have been disclosed in the drawings and specification. While the example embodiments have been described with reference to specific terms, it shall be understood that the terms used herein are only for the purpose of describing the technical scope of the present disclosure and not for limiting the scope of the present disclosure as defined in the claims. Therefore, those skilled in the art will appreciate that various modifications and equivalent embodiments are possible without departing from the scope of the present disclosure.

## Claims

1. An integrated circuit comprising:
a first cell (C41) placed in a first row (R41) extending in a first direction (X) and comprising a first pin above a substrate (SUB); and
a second cell (C42) placed in the first row (R41) and comprising a second pin above the substrate (SUB),
wherein the first pin and the second pin are included in a first pattern (M15) in a first wiring layer (M1) above the substrate (SUB), the first pattern (M15) extending in the first direction (X) along a boundary between the first row (R41) and a second row adjacent to the first row (R41).

2. The integrated circuit of claim 1, wherein each of the first cell (C41) and the second cell (C42) further comprises a backside pattern (BM11, BM12) extending in the first direction (X) below the substrate (SUB) and configured to provide a supply voltage to the first cell (C41) and the second cell (C42).

3. The integrated circuit of claim 2, wherein each of the first cell (C41) and the second cell (C42) further comprises:
a device on the substrate (SUB); and
a backside contact (TSV1, TSV2) between the device and the backside pattern (BM11, BM12).

4. The integrated circuit of any preceding claim, wherein the first cell (C41) further comprises a third pin extending in the first direction (X) in the first wiring layer, and
wherein a width of the first pattern (M15) is greater than a width of the third pin.

5. The integrated circuit of any preceding claim, wherein the first pin (M15) is an input pin, and
wherein the first cell (C41) further comprises a gate contact on the boundary between the first row (R41) and the second row, and electrically connected to the first pattern (M15).

6. The integrated circuit of claim 5, wherein the first cell (C41) further comprises a gate electrode (G51) extending in a second direction (Y) crossing the first direction (X) across the boundary between the first row (R41) and the second row, and
wherein the gate contact is between the gate electrode (G51) and the first pattern (M15).

7. The integrated circuit of any preceding claim, wherein the second pin is an output pin, and
wherein the second cell (C42) further comprises a source/drain contact (CA) extending in a second direction (Y) crossing the first direction (X) across the boundary between the first row (R41) and the second row and electrically connected to the first pattern (M15).

8. The integrated circuit of any preceding claim, wherein at least one of the first cell (C41) and the second cell (C42) is placed in the first row (R41) and the second row that are consecutive.

9. The integrated circuit of any preceding claim, wherein the first cell (C06) is placed in consecutive rows comprising the first row (R1), the second row (R2), and a third row (R3) which is adjacent to the second row (R2) and extends in the first direction (X), and
wherein the first cell (C06) comprises a first active pattern (NFET AP) extending in the first direction (X) along the boundary between the first row (R1) and the second row (R2).

10. The integrated circuit of claim 9, wherein the second cell (C08) further comprises a second active pattern (PFET AP) extending in the first direction (X) in the first row (R1), and
wherein a width of the first active pattern (NFET AP) is greater than a width of the second active pattern (PFET AP).

11. The integrated circuit of claim 10, further comprising a third cell (C07) between the first cell (C06) and the second cell (C08), and
wherein the first pattern (M83) extends in the first direction (X) across the third cell (C07).

12. An integrated circuit comprising:
a first cell (C41) comprising a first pin which extends in a first direction (X) along a boundary between a first row (R41) and a second row, which are adjacent to each other and extending in the first direction (X); and
a second cell (C42) comprising a second pin which extends in the first direction (X) along the boundary between the first row (R41) and the second row,
wherein the first pin and the second pin are merged as a first pattern (M15) in a first wiring layer (M1) on a substrate (SUB).

13. The integrated circuit of claim 12, wherein each of the first cell (C41) and the second cell (C42) further comprises:
a device on the substrate (SUB);
a backside pattern (BM11, BM12) extending in the first direction (X) below the substrate (SUB) and configured to provide a supply voltage to the first cell (C41) and the second cell (C42); and
a backside contact (TSV1, TSV2) between the device and the backside pattern (BM11, BM12).

14. The integrated circuit of claim 12 or claim 13, wherein the first cell (C41) further comprises a third pin extending in the first direction (X) in the first wiring layer (M1), and
a width of the first pattern (M15) is greater than a width of the third pin of the first cell (C41).

15. The integrated circuit of any of claims 12-14, further comprising a third cell (C73), which includes at least one fourth pin, adjacent to the first cell (C71) in the second row (R72), and
wherein the at least one fourth pin of the third cell (C73) is apart from the first pattern (M15).
